# EUROPEAN PATENT SPECIFICATION

(11) **EP 0 504 669 B1**
(45) Date of publication and mention of the grant of the patent: **07.05.1997**
(21) Application number: 92103777.6
(22) Date of filing: 05.03.1992
(51) Int. Cl.: H01L 21/58, H01L 21/48, H01L 23/14, H01L 23/482

(54) **Semiconductor device comprising a substrate**
Halbleiteranordnung mit Substrat
Dispositif semiconducteur comprenant un substrat

(30) Priority: 18.03.1991 JP 78561/91
(43) Date of publication of application: 23.09.1992
(73) Proprietor: JAPAN GORE-TEX, INC., Setagaya-ku Tokyo 156 (JP)
(72) Inventor: Fukutake, Sunao, Okayama-Shi, Okayama-Ken 703 (JP); Hatakeyama, Minoru, Akaiwa-Gun, Okayama-Ken 709-08 (JP); Hazaki, Yoshito, Okayama-Shi, Okayama-Ken 703 (JP); Urakami, Akira, Oku-Gun, Okayama-Ken 401-42 (JP)
(74) Representative: Klunker . Schmitt-Nilson . Hirsch

(56) References cited:
- EP-A- 0 051 165
- EP-A- 0 209 265
- EP-A- 0 285 051
- EP-A- 0 285 051
- EP-A- 0 412 323
- EP-A- 0 412 323
- WO-A-90/10680
- JP-A-62 210 630
- JP-A-62 210 631
- PATENT ABSTRACTS OF JAPAN vol. 13, no. 240 (E-767)6 June 1989

## Description

### FIELD OF THE INVENTION

The present invention relates to semiconductor apparatus intended to provide a product of superb quality by preventing malfunctioning, failure, and formation of cracks in the semiconductor elements, which are caused by mechanical stress from the outside and by thermal stress brought about by rapid temperature changes during mounting, actual use, and the like.

### BACKGROUND OF THE INVENTION

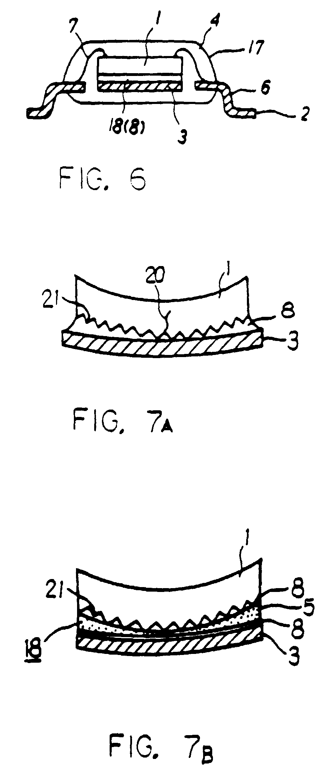

Conventional semiconductor devices, which are referred to as "integrated-circuit packages," are the devices as shown in Figure 6, wherein an integrated-circuit chip 1 is bonded to a chip pad 3 by a chip-bonding material 18, such as solder, silver paste, or hard epoxy resin, and is then sealed with a resin. In recent years, as electronic devices have gradually become more compact and as their performance has improved, these devices have come to be widely used as thin and compact integrated-circuit packages and other devices of a surface-mounted type.

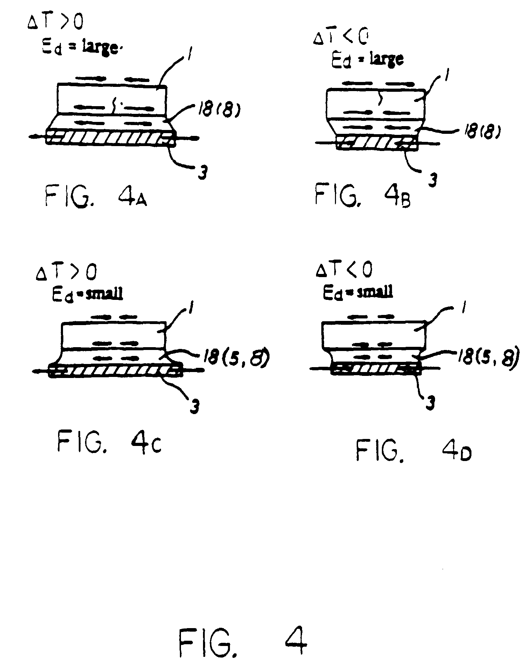

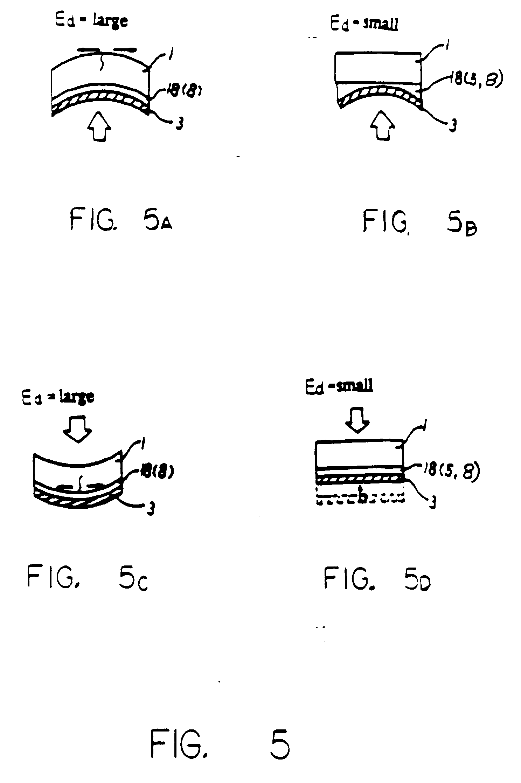

However, due to the high value of the Young's modulus of the chip-bonding material 18 that is used in the conventional devices described above, large thermal stress is generated by temperature differences in integrated-circuit chip 1, as shown in Figures 4A and 4B, causing malfunctioning and failure of integrated-circuit chip 1. In cases where an outside force is applied to the lower and upper portions of a package 17, as shown in Figures 5A and 5C, the chip is strictly confined between the integrated-circuit chip 1 and the chip pad 3, with the results that the integrated-circuit chip 1 tends to warp and is prone to failure.

In Japanese Laid-Open Patent Applications 62-210630 and 62-210631, which have been developed in order to overcome the disadvantages described above, a rubber-like elastic body having a low Young's modulus is used as the above chip-bonding material 18. The problem of thermal stress is dealt with by preventing the stress generated by a temperature difference from being transmitted to the integrated-circuit chip 1, as shown in Figures 4C and 4D. The problem of mechanical stress from the outside is solved by allowing the chip-bonding material 18 itself to deform as shown in Figures 5B and 5D to thus alleviate the stress generated in the integrated-circuit chip 1.

However, with the technique of Japanese Laid-Open Patent Applications 62-210630 and 62-210631 described above, a drop in the efficacy of wire bonding is caused by the chip-bonding material 18 which is a rubber-like elastic material with a low Young's modulus. Furthermore, since notches 21, which can cause cracks to be generated due to the "back-grinding" of an integrated-circuit chip, such as the one shown in Figure 7, cannot be covered securely, there is the shortcoming that cracks 20 readily form from the notches 21 when the face of the integrated-circuit chip 1 is warped to form a concave shape.

### SUMMARY OF THE INVENTION

The invention comprises a semiconductor device which carries an integrated-circuit chip or another semiconductor element on a substrate, wherein a porous polytetrafluoroethylene (PTFE) layer is positioned between the semiconductor element and the substrate, whereby a chip-bonding layer is formed by bonding a thermosetting resin to the porous PTFE layer either by coating or impregnation, or both. An inorganic filler may be incorporated into the chip-bonding layer.

In a semiconductor device that carries an integrated-circuit chip or other semiconductor element on a substrate, a porous PTFE layer is positioned between the semiconductor element and substrate. It is described in EP-A-0 412 323 that porous PTFE provides a low Young's modulus. A layer which displays a comparatively low Young's modulus of 2 to 40 kgf/mm², owing to the use of the porous PTFE, is thus interposed between the chip and substrate. Because of the presence of this layer, the stress which is generated inside the integrated-circuit chip is alleviated, thereby increasing the reliability of semiconductor devices.

By forming a chip-bonding layer wherein a thermosetting resin is bonded to a porous PTFE layer either by coating or impregnation, or both, elongation which is caused by temperature changes in a chip pad or other supporting substrate for an integrated-circuit chip is absorbed by this chip-bonding layer. The bending of an integrated-circuit chip by an outside load is alleviated and absorbed similarly.

By forming the chip-bonding layer as an epoxy resin layer with a comparatively high Young's modulus and by concurrently using a PTFE porous material with a low Young's modulus and excellent mechanical characteristics, such as ductility, effective adhesion is attained and strain and stress are alleviated in the presence of coarse notched portions of the chip that are caused by the "back-grinding" of the undersurface of an integrated-circuit chip.

Characteristics such as thermal conductivity and electric conductivity may be adjusted and improved by incorporating an inorganic filler into the chip-bonding layer.

### BRIEF DESCRIPTION OF THE DRAWINGS

Figure 1 is a cross-sectional view of one example of the semiconductor device of the present invention.

Figure 2 is an enlarged view of the main component of the chip-bonding portion of Figure 1.

Figure 3 is a cross-sectional view of an example of the invention implemented in a wiring board for COB.

Figure 4 and Figure 5 are diagrammatical views illustrating the mechanism of stress relaxation of integrated-circuit chips in the present invention.

Figure 6 is a cross-sectional view illustrating the structure of a conventional integrated-circuit package.

Figure 7 is a diagrammatical view which describes theoretically an increase in the fracture limit of an integrated-circuit chip or other semiconductor element of the invention.

### DETAILED DESCRIPTION OF THE INVENTION

The invention is now described with reference to the drawings to more clearly delineate the invention, materials used in its manufacture, and how it functions.

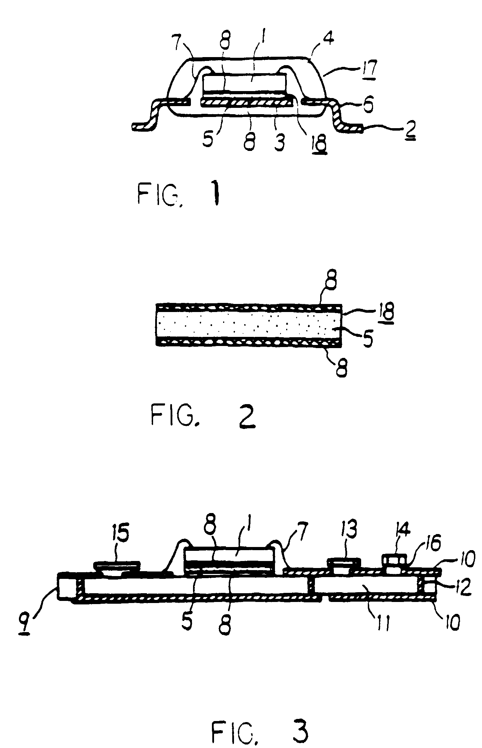

As shown in Figure 1, a semiconductor element, an integrated-circuit chip 1 is installed on a substrate 3 such as a chip pad, the electrodes of the semiconductor element 1 and a lead frame 2 are connected by a gold wire 7, and all these components are coated by a molding resin 4. However, in the present invention, a porous PTFE layer 5, a porous fluororesin body, is positioned between the semiconductor element 1 and the substrate 3 to serve as a chip-bonding material 18.

A PTFE film, which has been drawn into a porous component, is preferred as the porous PTFE layer 5. In this layer, fine pores of no more than 2 µm are formed, producing a porosity of 40 to 95%, preferably 60 to 80%. The fine pores thus produced transmit vapor and other gases, but do not transmit most liquids, possess superior mechanical characteristics because they are made fibrous by drawing, and display a comparatively low Young's modulus of 2 to 40 kgf/mm².

The stress reduction relationship provided by the above porous PTFE layer 5 is as follows. As shown in Figure 4, the linear expansion coefficient of substrate 3, which consists of a metal, is α_{Di} = 17 x 10⁻⁶ deg⁻¹, and is large compared to the linear expansion coefficient of the silicon semiconductor element 1, which is α_{Si} = 3 x 10⁻⁶ deg⁻¹. Although the thermal stress caused by this difference is large, such thermal stress is absorbed by layer 5 in a suitable manner. If the Young's modulus of this layer is high, considerable tensile stress is created on the undersurface of the semiconductor element 1, as shown in Figure 4A, when the temperature is raised and cracks are formed in element 1.

Silicon chips generally have a high rupture limit of approximately 50 kgf/mm² when subjected to compressive stress and a low rupture limit of approximately 10 kgf/mm² when subjected to tensile stress. Therefore, although cracks are formed in a semiconductor element 1, such as a silicon chip, when the tensile stress exceeds the rupture limit, the use of a layer 5 with a low Young's modulus in the manner described above ensures that the elongation of substrate 3 is absorbed in layer 5 as shown in Figure 4c, thereby inhibiting the generation of large stresses on both the upper and lower surfaces of element 1. The same is true when the temperature is lowered, in which case the contraction of substrate 3 is passed on to element 1 being considerably reduced through layer 5, thereby precluding damage to the chip.

Similar phenomena take place when a mechanical force is applied from the outside. When only solder, epoxy resin, or other materials with a high Young's modulus are used, substrate 3 and a semiconductor element 1, such as an integrated-circuit chip, are combined into a unit, the upper surface of element 1 is warped into a convex shape under the action of an outside force applied to an integrated-circuit package from below. Considerable tensile stress is then generated on the face of element 1 and cracks are formed. Furthermore, when element 1 and substrate 3 are combined into a unit similarly, the undersurface of the element 1 is warped into a convex shape under the action of an outside force applied to the integrated-circuit package from above. Considerable tensile stress is then generated on the undersurface of element 1 and cracks are formed.

In contrast to this, in the present invention wherein a porous PTFE layer 5 with a low Young's modulus is present, even when an outside mechanical force is applied to the integrated-circuit package from below and substrate 3 is bent, the stress is absorbed in layer 5 and the warping of element 1 can be prevented. The convex warping of the undersurface of element 1 by layer 5 can also be alleviated in the case of an outside force applied to the integrated-circuit package from above.

The undersurface of an integrated-circuit chip is coarse compared to its face because "back-grinding" is usually conducted in the process of its manufacture. Since notches on the undersurface easily become a source for the formation of cracks, a tensile stress applied to the undersurface of an integrated-circuit chip approximately half as high as that on the face thereof leads to rupture. It can thus be inferred that, in order to reinforce an integrated circuit chip, it is effective to cover the notched portion on the undersurface thereof with a material that has high adhesion power and a comparatively high Young's modulus.

Specifically, a combined effect such as has been described above is obtained in the present invention, whereby a bonding portion 18 with a sandwich structure, composed of an epoxy layer 8 with a high Young's modulus, is formed as shown in Figure 7B. The notched portion on the undersurface of element 1 is coated with an epoxy resin which displays a high Young's modulus and layer 5 alleviates the deformation of an integrated-circuit chip.

As a specific manufacturing example, a product such as the one shown in Figure 1 was obtained by using a component wherein epoxy resin layers 8 of about 5 µm in thickness were placed on the upper and lower surfaces of a porous PTFE layer 5 of about 20 µm in thickness as shown in Figure 2. Element 1 was bonded to substrate 3 through the agency of layer 5, with the joining being conducted in the following manner. A lead frame 2 was placed on a heating stage, bonding material 18 and element 1, which was an integrated-circuit chip, were mounted on the frame, and the epoxy resin was heated and caused to harden. The notches on the undersurface of element 1 were thus covered and reinforced, and the stress was alleviated by the deformational action of the porous PTFE in the manner described above, making it possible to increase considerably the fracture limit of integrated-circuit chips.

SiO₂ or other ceramic fillers may be intermixed with layer 5 and/or epoxy resin layer 8 to increase thermal conductivity, and nickel, titanium, copper or other metal powders may be intermixed to impart electric conductivity.

In addition, part of the pores in the porous PTFE layer may be impregnated with an epoxy resin, polyimide resin, or the like in order to somewhat increase the overall Young's modulus of the bonding portion 18, thereby to increase the efficacy of wire bonding and transfer molding.

When the chip-bonding material 18, which consisted of porous PTFE that has been coated on both sides with an epoxy resin in the manner shown in Figure 2, was used to mount an integrated-circuit chip directly on a printed wiring circuit board 9 by a COB (chip on board) method, it was possible to reduce significantly the stress that was generated in integrated-circuit chip 1 and to obtain a suitable mounted product which was devoid of crack formation and other defects, such as shown in Figure 3.

With the present invention, it is possible to adequately eliminate the thermal and mechanical stress generated in integrated-circuit chips, to securely prevent element malfunction and crack formation, to maintain satisfactory chip and circuit characteristics, and to provide highly reliable products.

## Claims

1. A semiconductor device comprising in order:
(a) a substrate,
(b) positioned on said substrate a layer; and (c) a semiconductor element positioned over said layer,
**characterized in that** said layer is a porous polytetrafluoroethylene layer, said layer is bonded to said semiconductor element by an interposed chip bonding layer, and said chip bonding layer comprises a thermosetting resin coated on said porous polytetrafluoroethylene layer and/or impregnated in said porous polytetrafluoroethylene layer.

2. The semiconductor device of claim 1, **characterized in that** said semiconductor element comprises an integrated circuit chip.

3. The semiconductor device of claim 1 or 2, **characterized in that** said chip bonding layer and/or said porous polytetrafluoroethylene layer incorporate an inorganic filler.

## Patentansprüche

1. Eine Halbleitervorrichtung umfassend der Reihe nach:
(a) ein Substrat,
(b) eine auf dem Substrat positionierte Schicht; und
(c) ein über der Schicht positioniertes Halbleiterelement,
**dadurch gekennzeichnet**, daß die Schicht eine poröse Polytetrafluorethylenschicht ist, wobei die Schicht mit dem Halbleiterelement mittels einer dazwischen liegenden Chipklebeschicht verklebt ist, und die Chipklebeschicht ein warmaushärtendes Harz umfaßt, mit dem die poröse Polytetrafluorethylenschicht beschichtet und/oder imprägniert ist.

2. Die Halbleitervorrichtung nach Anspruch 1, **dadurch gekennzeichnet**, daß das Halbleiterelement einen IC-Chip umfaßt.

3. Die Halbleitervorrichtung nach Anspruch 1 oder 2, **dadurch gekennzeichnet**, daß die Chipklebeschicht und/oder die poröse Polytetrafluorethylenschicht ein anorganisches Füllmittel enthalten.

## Revendications

1. Un dispositif semi-conducteur comprenant dans l'ordre :
(a) un substrat,
(b) une couche positionnée sur ledit substrat ; et
(c) un élément semi-conducteur positionné au dessus de ladite couche,
caractérisé en ce que ladite couche est une couche de polytétrafluoréthylène poreux, ladite couche est liée audit élément semi-conducteur par une couche interposée de liaison de microplaquette et ladite couche de liaison de microplaquette comprend une résine thermodurcissable appliquée sur ladite couche de polytétrafluoréthylène poreux et/ou imprégnée dans ladite couche de polytétrafluoréthylène poreux.

2. Le dispositif semi-conducteur selon la revendication 1, caractérisé en ce que ledit élément semi-conducteur comprend une microplaquette de circuit intégré.

3. Le dispositif semi-conducteur selon la revendication 1 ou 2, caractérisé en ce que ladite couche de liaison de microplaquette et/ou ladite couche de polytétrafluoréthylène poreux incorporent une charge inorganique.
